# EUROPEAN PATENT SPECIFICATION

(11) **EP 4 312 372 B1**
(45) Date of publication and mention of the grant of the patent: **03.06.2026**
(21) Application number: 22186968.8
(22) Date of filing: 26.07.2022
(51) Int. Cl.: H03K 17/96, H02G 3/12

(54) **PARAMETRIZABLE CONTROL PAD, AND PARAMETRIZATION METHOD FOR A CONTROL PAD FOR BUILDING INSTALLATIONS**
PARAMETRISIERBARES STEUERFELD UND PARAMETRIERUNGSVERFAHREN FÜR EIN STEUERFELD FÜR GEBÄUDEINSTALLATIONEN
TABLEAU DE COMMANDE PARAMÉTRABLE ET PROCÉDÉ DE PARAMÉTRAGE D'UN TABLEAU DE COMMANDE POUR DES INSTALLATIONS DE BÂTIMENT

(43) Date of publication of application: 31.01.2024
(73) Proprietor: ABB SCHWEIZ AG, 5400 Baden (CH)
(72) Inventor: ZIERACH, Falk, 58762 Altena (DE); KEMPER, Jürgen, 59425 Unna (DE); WIESE, Michael, 42897 Remscheid (DE); KLOY, Olaf, 42389 Wuppertal (DE); KREUTZBERG, Steffen, 59174 Kamen (DE)
(74) Representative: Zimmermann & Partner Patentanwälte mbB

(56) References cited:
- EP-A1- 2 665 189
- EP-B1- 2 363 956
- DE-A1- 102020 126 110
- US-B1- 6 396 007

## Description

### TECHNICAL FIELD

The disclosure generally relates to a parametrizable control pad, and a parametrization method for a control pad for building installations.

### BACKGROUND

Automation of building installations is advancing. In this context, manual control of building installations is increasingly replaced by electronic equivalents. The term building installations, as used herein, refers to installations of interior as well as exterior spaces, such as lightening, air conditioning, heating, (rolling) shutters, blinds, comfort scenes, windows, or gates. The number, as well as type of building installations may vary from space to space, as well as over the lifetime of a building, for instance, due to renovation. Therefore, a great number of different control pads, each control pad reflecting the number of building installations in a space, may become necessary. In addition, modifications of building installation, for instance due to a renovation, may render already present control pads useless, thereby requiring their replacement. A single, more versatile control pad which provides operating functions more flexibly may help to reduce resources of both, material and man hour.

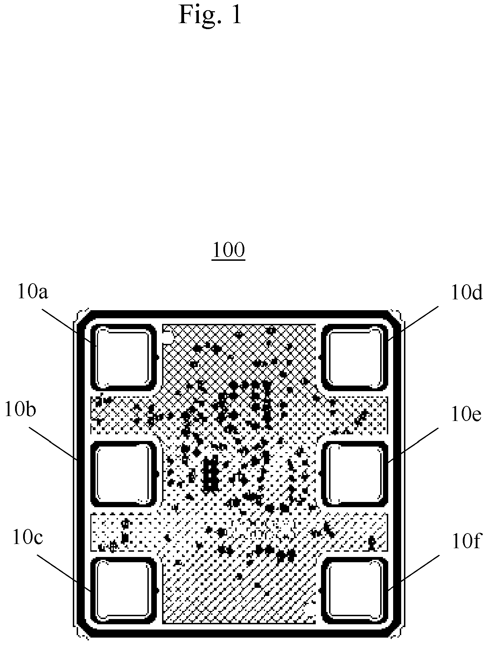

According to the conventional technology, for example, a control pad is provided with a fixed number of operating elements. Examples of such control pads include, for instance, a one-fold, two- fold or multi- fold switch. Hardware permanently implements each of the fixed number of operating elements. Variants are typically realized via differences in electro-mechanics and/ or electronics between control pads. In electro-mechanics, variants are realized by a respective combination of individually pronounced pushbuttons, rockers or buttons. In electronics, variants are realized by a respective number of distinctive operating elements, as illustrated by Fig. 1.

Fig. 1 illustrates a schematic diagram of a control pad according to prior art. The control pad 100 provides six distinctive operating elements 10a - 10f. It may thus form the basis of a sixfold switch. The operation elements 10a - 10f are distinctively provided by a corresponding number of hardware components. The hardware components specify the number of operation elements 10a - 10f the control pad 100 can provide. Not all of the operation elements 10a - 10f need to be used. The control pad 100 may as well be implemented as a two-fold or four-fold switch by using only a corresponding number of the operation elements 10a - 10f. Each of the operation elements 10a - 10f may be used to control a building installation. For instance, operation element 10a may be used to control lightening, while operation element 10b may be used to control blinds.

In a space where more than six building installations are to be implemented and controlled, the control pad 100 and its operation elements 10a - 10f are insufficient. It is, thus, favorable to provide a single, more versatile control pad, thereby extending its usage time and application range.

Publications EP 2 665 189 A1, US 6 396 007 B1, EP 2 363 956 B1 and DE 10 2020 126110 A1 disclose prior art control pads.

### SUMMARY OF THE DISCLOSURE

A parametrizable control pad and a parametrization method according to the invention are defined in appended independent claims 1 and 12. Preferred embodiments are defined in the dependent claims.

Operation function, as used herein, may refer to a virtual representation of an operation element, such as a switch or a predefined input gesture by a user. The operation function serves as a flexible input interface that may be adjusted anytime by a respective parametrization using software code and/ or a parameter set. Thus, no hardware modifications are necessary for adjusting the control pad. In some cases, one operation function may be used to control a single building installation, while, in other cases, a single operation function may be used to control a plurality of building installations. Although used interchangeably in some cases, operation function generally refers herein to a virtual representation of an operation element.

Parameterization, as used herein, may refer to a specification or configuration of the control pad. The parametrization may be provided as software code and/ or a parameter set that is to be implemented by the control unit. The implementation may be facilitated by a program, an application and/ or dedicated tool, that is publicly and/ or commercially available, such as the ETS software. Once the control pad is parametrized, the capacitive area sensor virtually represents the operation elements.

The control signal may actuate one or more building installations or a specific function thereof. Examples include a control signal that causes a lamp to be switched on or off; brightness of a lamp to be increased or decreased; or a window to be opened or closed. In some cases, an operation function may define the control signal to also include a specific time to elapse before actuating a building installation. For example, an operation function may define actuating a building installation in 1 minute in response to a user input.

### BRIEF DESCRIPTION OF THE DRAWINGS

Fig. 1 illustrates a schematic diagram of a PCBA of a control pad according to prior art;
Fig. 2 illustrates a schematic side view of a parametrizable control pad according to an embodiment described herein.
Fig. 3 illustrates a schematic diagram of parametrizable control pad according to an embodiment;
Fig. 4 illustrates a schematic diagram of a first side of a printable circuit board according to embodiments described herein.
Fig. 5 illustrates a schematic diagram of a parametrization method for a control pad according to an embodiment.

### DESCRIPTION OF EMBODIMENTS

In the following, embodiments are set forth to describe specific examples presented herein. The person skilled in the art will recognize that one or more other examples and/ or variations of these examples may be practiced without all the specific details outlined below. Also, well known features may not be described in detail so as not to obscure the description of the examples herein. For the ease of illustration, like reference numerals are used in different figures to refer to the same elements or additional instances of the same element. Features illustrated or described as part of one embodiment can be used on or in conjugation with any other embodiment to yield yet a further embodiment.

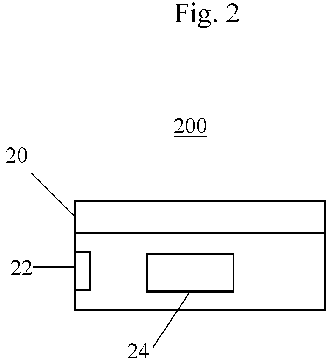

Referring now to the drawings, Fig. 2 presents a side view of a parametrizable control pad 200 configured to control at least one building installation by a user according to an embodiment described herein. The control pad 200 has a capacitive area sensor 20. The capacitive area sensor 20 may span the entire surface of the control pad 200. The control pad 200 further has an interface unit 22. The interface unit 22 serves to receive input, such as a parametrization for the capacitive area sensor 20. A logic unit 24 of the control pad 200 serves to parametrize the capacitive area sensor 20 according to a received parametrization such that the capacitive area sensor 20 represents the one or more operation elements provided by the parametrization. The logic unit 24 also serves to convert a user input to the one or more operation function into a control signal for at least one building installation.

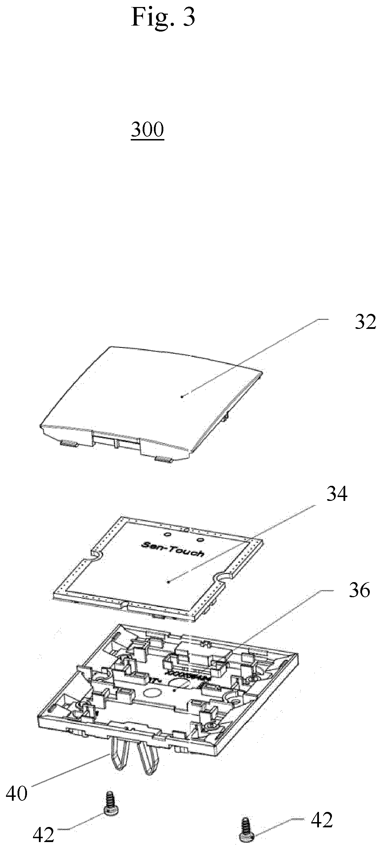

Fig. 3 illustrates a schematic diagram of parametrizable control pad 300 according to a further embodiment. The control pad is presented in an exploded manner. The control pad 300 can have a technical cover 32 as an outer surface of the control pad 300. The technical cover 32 may be connected with the printable circuit board, PCBA, 34 which may carry the capacitive area sensor on one side, and a plurality of LED at the other side, the other side facing downward in this Fig. The technical cover 32 may be the interface of the control pad 300 to the environment. As shown, the capacitive area sensor may span the entire surface of the PCBA 34 which corresponds to the area of the control pad 300.

A clamping arrangement 40 may be provided at the side of the sensor base 36 opposite to the side accommodating the PCBA 34. The clamping arrangement 40 may serve to fasten the control pad 300 at a flush-mounted insert (not shown) and may serve as an electro-mechanical interface in connection with the flush-mounted insert. The control pad 300 can be assembled by screws 42 and mounted, in its assembled form, to a flush-mounted insert.

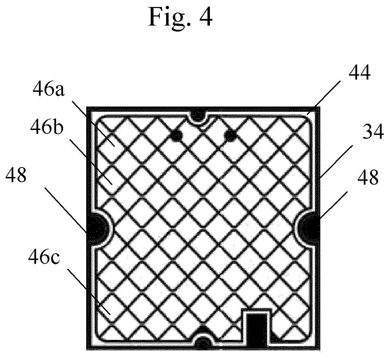

Fig. 4 illustrates a schematic diagram of a top side of the PCB 34 according to an embodiment. This side of the PCBA 34 may carry the capacitive area sensor 44. When the control pad is in use, the first top of the PCBA 34 may face towards a potential user or the environment. As illustrated, the capacitive area sensor 44 can have individual electrodes, which are arranged in a matrix. The electrodes are here exemplarily referred to as 46a, 46b, 46c. The number of individual electrodes may deviate from the one illustrated. The electrodes may be connected to a microcontroller which evaluates a user's touch and its position captured by the electrodes. Side recesses 48 can serve to assemble the PCB 34 within the control pad 300. The individual electrodes 46a, 46b, 46c may be grouped together to actuating fields (not shown).

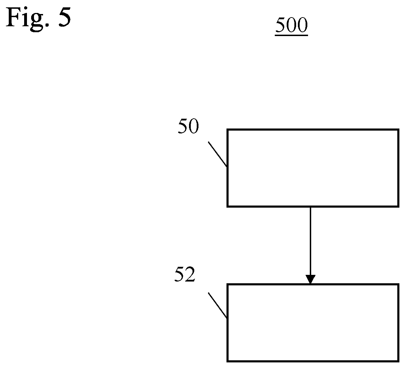

Referring now to Fig. 5 which illustrates a schematic diagram of a parametrization method 500 for a control pad according to an embodiment. The method 500 provides for receiving 50, by the user interface a parameterization for the capacitive area sensor, the parametrization comprising at least one operation function. The method 500 further provides for parametrizing 52, by the logic unit, the capacitive area sensor according to the parameterization such that the capacitive area sensor is configured to detect a user input to the at least one operation element and the logic unit is further configured to convert the user input to the at least one operation element into a control signal for the at least one building installation.

Embodiments and/ or features described herein with respect to the parametrization method may be implemented equally within the control pad and vice versa.

## Claims

1. A parametrizable control pad (200) configured to control at least one building installation by a user, the control pad comprising:
- a capacitive area sensor (20), the capacitive area sensor comprising an electrically capacitive surface to detect the position of one or more fingers on the surface, the capacitive area sensor comprising a plurality of electrodes that are distributed in a regular pattern over the area of the capacitive area sensor;
- an interface unit (22) configured to receive a parameterization for the capacitive area sensor, the parametrization comprising at least one operation function;
- a logic unit (24) configured to parametrize the capacitive area sensor according to the parameterization;
wherein, when parametrized according to the parameterization, the capacitive area sensor is configured to detect a user input to the at least one operation function;
wherein the logic unit is configured to convert the user input to the at least one operation function into a control signal for the at least one building installation; and
wherein the electrodes of the capacitive area sensor are connected to the logic unit which is configured to evaluate the user input and its position captured by the electrodes.

2. The parametrizable control pad according to claim 1, further comprising a BUS interface, wherein the BUS interface is configured to transmit the control signal to a control system of the at least one building installation.

3. The parametrizable control pad according to any of the preceding claims, wherein the capacitive area sensor spans the entire area of the control pad.

4. The parametrizable control pad according to any of the preceding claims, wherein the capacitive area sensor is touch-sensitive.

5. The parametrizable control pad according to any of the preceding claims, the parameterization further comprising a type of the at least one operation function.

6. The parametrizable control pad according to any of the preceding claims, the parametrization further comprising an arrangement of the at least one operation function within the capacitive area sensor.

7. The parametrizable control pad according to claim 5 or 6, wherein the type of each of the at least one operation function comprises a virtual representation of an electro-mechanical switch or a predefined input gesture by a user.

8. The parametrizable control pad according to claim 6 or 7, wherein the arrangement of the at least one operation function corresponds to a single-fold switch or multi-fold switch.

9. The parametrizable control pad according to any of the preceding claims, further comprising a printable circuit board, PCB, wherein the capacitive area sensor is arranged at one side of the PCB.

10. The parametrizable control pad according to the preceding claim, further comprising a sensor base, wherein the sensor base is configured to accommodate the PCB at a first side.

11. The parametrizable control pad according to the preceding claim, wherein the sensor base comprises a clamping arrangement at a second side, wherein the clamping arrangement is configured to fasten the control pad on a flush-mounted insert.

12. Parametrization method (500) to parametrize a control pad according to any of the preceding claims, the method comprising:
- Receiving (50), by the user interface, a parameterization for the capacitive area sensor, the parametrization comprising at least one operation function;
- Parametrizing (52), by the logic unit, the capacitive area sensor according to the parameterization such that the capacitive area sensor is configured to detect a user input to the at least one operation function and the logic unit is further configured to convert the user input to the at least one operation function into a control signal for the at least one building installation.

## Patentansprüche

1. Parametrisierbares Steuerfeld (200), das ausgelegt ist, mindestens eine Gebäudeinstallation durch einen Benutzer zu steuern, das Steuerfeld umfassend:
- einen kapazitiven Flächensensor (20), wobei der kapazitive Flächensensor eine elektrisch kapazitive Oberfläche umfasst, um die Position eines oder mehrerer Finger auf der Oberfläche zu erfassen, wobei der kapazitive Flächensensor eine Vielzahl von Elektroden umfasst, die in einem regelmäßigen Muster über die Fläche des kapazitiven Flächensensors verteilt sind;
- eine Schnittstelleneinheit (22), die dazu ausgelegt ist, eine Parametrisierung für den kapazitiven Flächensensor zu empfangen, wobei die Parametrisierung mindestens eine Betriebsfunktion umfasst;
- eine Logikeinheit (24), die dazu ausgelegt ist, den kapazitiven Flächensensor gemäß der Parametrisierung zu parametrisieren;
wobei der kapazitive Flächensensor, wenn gemäß der Parametrisierung parametrisiert, dazu ausgelegt ist, eine Benutzereingabe in die mindestens eine Betriebsfunktion zu detektieren;
wobei die Logikeinheit dazu ausgelegt ist, die Benutzereingabe in die mindestens eine Betriebsfunktion in ein Steuersignal für die mindestens eine Gebäudeinstallation umzuwandeln; und
wobei die Elektroden des kapazitiven Flächensensors mit der Logikeinheit verbunden sind, die dazu ausgelegt ist, die Benutzereingabe und deren von den Elektroden erfasste Position auszuwerten.

2. Parametrisierbares Steuerfeld nach Anspruch 1, ferner umfassend eine BUS-Schnittstelle, wobei die BUS-Schnittstelle dazu ausgelegt ist, das Steuersignal an ein Steuersystem der mindestens einen Gebäudeinstallation zu übertragen.

3. Parametrisierbares Steuerfeld nach einem der vorhergehenden Ansprüche, wobei sich der kapazitive Flächensensor über die gesamte Fläche des Steuerfelds erstreckt.

4. Parametrisierbares Steuerfeld nach einem der vorhergehenden Ansprüche, wobei der kapazitive Flächensensor berührungsempfindlich ist.

5. Parametrisierbares Steuerfeld nach einem der vorhergehenden Ansprüche, wobei die Parametrisierung ferner einen Typ der mindestens einen Betriebsfunktion umfasst.

6. Parametrisierbares Steuerfeld nach einem der vorhergehenden Ansprüche, wobei die Parametrisierung ferner eine Anordnung der mindestens einen Betriebsfunktion innerhalb des kapazitiven Flächensensors umfasst.

7. Parametrisierbares Steuerfeld nach Anspruch 5 oder 6, wobei der Typ jeder der mindestens einen Betriebsfunktion eine virtuelle Darstellung eines elektromechanischen Schalters oder eine vordefinierte Eingabegeste durch einen Benutzer umfasst.

8. Parametrisierbares Steuerfeld nach Anspruch 6 oder 7, wobei die Anordnung der mindestens einen Betriebsfunktion einem einfachen Schalter oder mehrfachen Schalter entspricht.

9. Parametrisierbares Steuerfeld nach einem der vorhergehenden Ansprüche, ferner umfassend eine Leiterplatte (PCB), wobei der kapazitive Flächensensor auf einer Seite der Leiterplatte angeordnet ist.

10. Parametrisierbares Steuerfeld nach dem vorhergehenden Anspruch, ferner umfassend eine Sensorbasis, wobei die Sensorbasis dazu ausgelegt ist, die Leiterplatte auf einer ersten Seite aufzunehmen.

11. Parametrisierbares Steuerfeld nach dem vorhergehenden Anspruch, wobei die Sensorbasis an einer zweiten Seite eine Klemmanordnung umfasst, wobei die Klemmanordnung dazu ausgelegt ist, das Steuerfeld an einem bündig montierten Einsatz zu befestigen.

12. Parametrisierungsverfahren (500) zum Parametrisieren eines Steuerfelds nach einem der vorhergehenden Ansprüche, das Verfahren umfassend:
- Empfangen (50), durch die Benutzerschnittstelle, einer Parametrisierung für den kapazitiven Flächensensor, wobei die Parametrisierung mindestens eine Betriebsfunktion umfasst;
- Parametrisieren (52), durch die Logikeinheit, des kapazitiven Flächensensors gemäß der Parametrisierung, sodass der kapazitive Flächensensor dazu ausgelegt ist, eine Benutzereingabe in die mindestens eine Betriebsfunktion zu detektieren, und die Logikeinheit ferner dazu ausgelegt ist, die Benutzereingabe in die mindestens eine Betriebsfunktion in ein Steuersignal für die mindestens eine Gebäudeinstallation umzuwandeln.

## Revendications

1. Pavé de commande paramétrable (200) configuré pour commander au moins une installation de bâtiment par un utilisateur, le pavé de commande comprenant :
- un capteur surfacique capacitif (20), le capteur surfacique capacitif comprenant une surface électriquement capacitive pour détecter la position d'un ou de plusieurs doigts sur la surface, le capteur surfacique capacitif comprenant une pluralité d'électrodes réparties selon un motif régulier sur l'étendue du capteur surfacique capacitif ;
- une unité d'interface (22) configurée pour recevoir un paramétrage pour le capteur surfacique capacitif, le paramétrage comprenant au moins une fonction d'opération ;
- une unité logique (24) configurée pour paramétrer le capteur surfacique capacitif selon le paramétrage ;
lorsqu'il est paramétré selon le paramétrage, le capteur surfacique capacitif étant configuré pour détecter une entrée utilisateur appliquée à l'au moins une fonction d'opération ; et
l'unité logique étant configurée pour convertir l'entrée d'utilisateur appliquée à l'au moins une fonction d'opération en un signal de commande pour l'au moins une installation de bâtiment ; et
les électrodes du capteur surfacique capacitif étant reliées à l'unité logique qui est configurée pour évaluer l'entrée utilisateur et sa position captée par les électrodes.

2. Pavé de commande paramétrable selon la revendication 1, comprenant en outre une interface BUS, l'interface BUS étant configurée pour transmettre le signal de commande à un système de commande de l'au moins une installation de bâtiment.

3. Pavé de commande paramétrable selon l'une quelconque des revendications précédentes, dans lequel le capteur surfacique capacitif couvre toute l'étendue du pavé de commande.

4. Pavé de commande paramétrable selon l'une quelconque des revendications précédentes, dans lequel le capteur surfacique capacitif est tactile.

5. Pavé de commande paramétrable selon l'une quelconque des revendications précédentes, le paramétrage comprenant en outre un type de l'au moins une fonction d'opération.

6. Pavé de commande paramétrable selon l'une quelconque des revendications précédentes, le paramétrage comprenant en outre un agencement de l'au moins une fonction d'opération à l'intérieur du capteur surfacique capacitif.

7. Pavé de commande paramétrable selon la revendication 5 ou 6, dans lequel le type de chacune de l'au moins une fonction d'opération comprend une représentation virtuelle d'un interrupteur électromécanique ou d'un geste d'entrée prédéfini par un utilisateur.

8. Pavé de commande paramétrable selon la revendication 6 ou 7, dans lequel l'agencement de l'au moins une fonction d'opération correspond à un interrupteur simple ou multiple.

9. Pavé de commande paramétrable selon l'une quelconque des revendications précédentes, comprenant en outre une carte de circuit imprimé, PCB, le capteur surfacique capacitif étant agencé au niveau d'un côté de la PCB.

10. Pavé de commande paramétrable selon la revendication précédente, comprenant en outre une base de capteur, la base de capteur étant configurée pour accueillir la PCB au niveau d'un premier côté.

11. Pavé de commande paramétrable selon la revendication précédente, dans lequel la base de capteur comprend un agencement de serrage au niveau d'un deuxième côté, l'agencement de serrage étant configuré pour fixer le pavé de commande sur un insert encastré.

12. Procédé de paramétrage (500) pour paramétrer un pavé de commande selon l'une quelconque des revendications précédentes, le procédé comprenant :
- la réception (50), par l'interface utilisateur, d'un paramétrage pour le capteur surfacique capacitif, le paramétrage comprenant au moins une fonction d'opération ;
- le paramétrage (52), par l'unité logique, du capteur surfacique capacitif selon le paramétrage de sorte que le capteur surfacique capacitif soit configuré pour détecter une entrée utilisateur appliquée à l'au moins une fonction d'opération et que l'unité logique soit configurée en outre pour convertir l'entrée utilisateur appliquée à l'au moins une fonction d'opération en un signal de commande pour l'au moins une installation de bâtiment.
